# EUROPEAN PATENT APPLICATION

(11) **EP 2 348 543 A1**
(43) Date of publication of application: **27.07.2011**
(21) Application number: 10186881.8
(22) Date of filing: 07.10.2010
(51) Int. Cl.: H01L 31/042, H01L 31/048

(54) **Flexible photovoltaic module**

(30) Priority: 22.01.2010 IT PD20100008
(71) Applicant: Naizil S.P.A., 35011 Campodarsego (PD) (IT)
(72) Inventor: Ziliotto, Alberto, 35010, Cadoneghe PD (IT)
(74) Representative: Modiano, Micaela Nadia

(57) **Abstract**

A flexible photovoltaic module (10) comprising a base layer (11) which is mated, by interposition of an intermediate junction element (12) made of polymeric material, with a photovoltaic film (13).

## Description

The present invention relates to a flexible photovoltaic module.

With the increasing spread of photovoltaic modules, there is also a growing need for these modules to be easily adaptable also to coverings that are not flat such as tensioned structures, pressostatic shed structures, truck tarpaulins, and other, similar coverings including coverings that are not permanent.

Such coverings are not capable of carrying standard photovoltaic panels, the weight of which, including a metal support frame, is on the average 15 kilograms per square metre; nor are such traditional photovoltaic panels capable of adapting to the geometries of the above mentioned coverings, which are often curved.

Nowadays photovoltaic films are widely known, which are of contained thickness and relatively low weight, and supported by flexible supports, for example a film of plastics based on polytetrafluoroethylene (PTFE) on a fibreglass sheet, or a thin layer of ethylene tetrafluoroethylene (ETFE), the flexible supports of which, in order to be applied on the above mentioned coverings, require the use of specific primers and fabrication times that are long and therefore expensive.

The aim of the present invention is to provide a flexible photovoltaic module that is capable of overcoming the drawbacks of known photovoltaic films.

Within this aim, an object of the invention is to provide a flexible photovoltaic module that can be used to make coverings, including coverings that are not flat, such as tensioned structures, pressostatic shed structures, truck tarpaulins, sun shades and other, similar coverings including coverings that are not permanent.

A further object of the invention is to offer a flexible photovoltaic module that is easy to use and can be produced using known systems and technologies.

This aim, as well as these and other objects which will become better apparent hereinafter, are achieved by a flexible photovoltaic module, characterized in that it comprises a base layer which is mated, by interposition of an intermediate junction element made of polymeric material, with a photovoltaic film.

Further characteristics and advantages of the invention will become better apparent from the following detailed description of a preferred, but not exclusive, embodiment of the flexible photovoltaic module according to the invention, illustrated, by way of non-limiting example, in the accompanying drawings wherein:

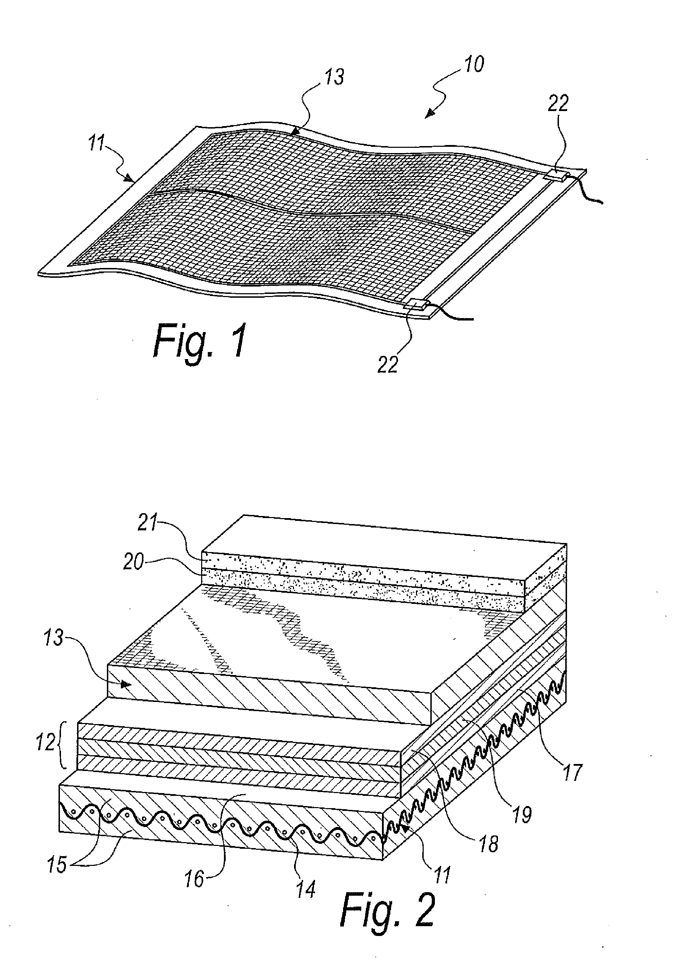

Figure 1 is a perspective view of a photovoltaic module according to the invention;
Figure 2 is a perspective sectional view of a portion of a photovoltaic module according to the invention.

With reference to the figures, a flexible photovoltaic module according to the invention is designated generally by the reference numeral 10. The module 10 comprises a base layer 11 which is mated, by interposition of an intermediate junction element 12 made of polymeric material, with a photovoltaic film 13.

The base layer 11 is obtained from a fabric selectively chosen among a spread fabric or a similar fabric obtained by calendering or spreading, or another similar and equivalent fabric.

The base layer 11 comprises a supporting fabric 14 that is covered with one or more layers 15 of plastics.

Tha layers 15 can be deposited by spreading, by calendering or with other similar and equivalent techniques.

Specifically, the supporting fabric 14 can be chosen from a high-tenacity polyester fabric, an acrylic fibre fabric, a glass fibre fabric, or a mesh of metallic material, or another similar and equivalent fabric.

The one or more spread layers 15, made of plastics, can be made of at least one material selectively chosen among polyvinylchloride, polyurethane, polyacrylate, synthetic rubber or other similar and equivalent plastic materials.

The surface 16 of such spread fabric is treated by lacquering or with acrylic resin or with a mixture of acrylic resin and fluorinated resin (PVDF - polyvinylidene fluoride), or with fluorinated resin.

The intermediate junction element 12 comprises a first sublayer 17, which is compatible with the lacquered surface 16, a second sublayer 18, which is compatible with the photovoltaic film 13, and a third layer 19, which is intermediate between the first sublayer 17 and the second sublayer 18, and is compatible with the first sublayer 17 and the second sublayer 18.

The first sublayer 17 is a film of plastics based on thermoplastic polyurethane elastomers.

The second sublayer 18 is a film of plastics based on ethyl vinyl acetate (EVA). The intermediate sublayer 19 is a film made of plastics based on polytetrafluoroethylene (PTFE) polymers or based on ethylene tetrafluoroethylene (ETFE).

The photovoltaic film 13 can be obtained on the market, encapsulated between two protective EVA films, a first one of such two films being formed by the second sublayer 18, cooperating with the junction of the photovoltaic film with the base layer 11 of spread fabric.

The second protective EVA film associated with the commercially available photovoltaic film 13 is formed by a first protective outer layer 20, made of plastics based on ethyl vinyl acetate.

The spread fabric, of a type that is *per se* known, and the photovoltaic film 13, also of a type that is *per se* known, are mated via the use of a rolling mill, or of another hot coupling system.

During the hot coupling operation, the first sublayer 17 and the intermediate sublayer 19 are interposed between the spread fabric and the photovoltaic film 13, sandwiched between the second sublayer 18 made of EVA and the first protective outer layer 20, whereas above the first protective outer layer 20 a second protective outer layer 21 is applied, made of plastics based on PTFE polymers or on ETFE polymers.

The use of the first junction sublayer 17 and of the intermediate layer 19 is necessary because of the incompatibility in terms of adhesion between the lacquered surface 16 of the spread tissue and the film made of EVA, i.e. the second junction sublayer 18, which protects the photovoltaic film 13.

Therefore the two sublayers 17 and 19 were identified and found to be compatible, in terms of adhesion, one, the first sublayer 17, with the lacquered surface 16, and the other, the intermediate sublayer 19, with the film made of EVA which is also the second junction sublayer 18.

The type of sublayers used, and their sequence, make it possible to apply the photovoltaic film to the base layer made of spread fabric and, at the same time, to protect it from the mechanical and chemical action caused by prolonged exposure to the outside.

Therefore, each sublayer between the base layer 11 and the photovoltaic film 13 adheres both to the underlying layer and to the overlying layer, thus bonding between them two flexible bodies which, in direct contact, would not be compatible with each other in terms of adhesion.

To resolve the problem, following long and meticulous research and related experimentation, the solution was found of using a film based on thermoplastic polyurethane elastomers (TPU) or a film based on thermoplastic polyolefins (TPO), which possess a good level of compatibility both with the lacquered surface 16 of the spread fabric and with the EVA, to form the first sublayer 17.

These polymers based on thermoplastic polyurethane elastomers (TPU) or on thermoplastic polyolefins (TPO) are, however, considered to be capable of compromising the metallic connections of the photovoltaic film 13, if they are in direct contact with them, and therefore capable of compromising the functioning of the module.

For this reason, between the first sublayer 17 and the second sublayer 18 made of EVA, the additional intermediate sublayer 19, based on fluorinated polymers, is interposed.

The photovoltaic film 13, which is of a known type, is for example constituted by strips of amorphous silicon cells, of a thickness comprised between 0.1 and 20 microns, electrically interconnected on a film of metallic material.

The photovoltaic module 10 is completed by junction blocks 22 for its wiring.

In practice it has been found that the invention fully achieves the intended aim and objects.

In particular, with the invention a flexible photovoltaic module has been devised that can be used to make coverings, including coverings that are not flat, such as tensioned structures, pressostatic shed structures, truck tarpaulins, and other, similar coverings including coverings that are not permanent, simply by placing or supporting the module according to the invention with the same systems with which a spread fabric of a known type is positioned and supported.

More specifically, with the invention a photovoltaic module has been provided that, owing to the base layer made of spread fabric or calendered fabric or the like, with layers of PVC, can be easily mated, by high-frequency welding, or by hot-air welding, or with other, similar systems that are easily and rapidly employed, to the most commonly used supporting coverings in tensioned structures, pressostatic shed structures, and to tarpaulins for trucks and trailers and the like.

The use of high-frequency welding techniques, or hot air welding techniques, or the like, which are *per se* known and widespread, renders the application and use of a module according to the invention much simpler, faster and economical than the means and times that would be necessary for applying known types of photovoltaic film.

Furthermore, with the invention a flexible photovoltaic module has been devised that is much more lightweight than traditional photovoltaic panels.

Last but not least, with the invention a flexible photovoltaic module has been provided that is easy to use and can be produced using known systems and technologies.

The invention thus conceived is susceptible of numerous modifications and variations, all of which are within the scope of the appended claims; moreover, all the details may be substituted by other, technically equivalent, elements.

In practice the materials employed, as well as the dimensions and the contingent shapes, may be any according to requirements and to the state of the art.

The disclosures in Italian Patent Application No. PD2010A000008 from which this application claims priority are incorporated herein by reference.

Where technical features mentioned in any claim are followed by reference signs, such reference signs have been inserted for the sole purpose of increasing the intelligibility of the claims and accordingly such reference signs do not have any limiting effect on the interpretation of each element identified by way of example by such reference signs.

## Claims

1. A flexible photovoltaic module (10), **characterized in that** it comprises a base layer (11) which is mated, by interposition of an intermediate junction element (12) made of polymeric material, with a photovoltaic film (13).

2. The photovoltaic module according to claim 1, **characterized in that** said base layer is made of spread fabric, said spread fabric of the base layer (11) comprising a supporting fabric (14) covered with one or more layers (15) of plastics.

3. The photovoltaic module according to the preceding claims, **characterized in that** said supporting fabric (14) is a high-tenacity polyester fabric or an acrylic fibre fabric or a glass fibre fabric or a mesh of metallic material or another similar and equivalent fabric.

4. The photovoltaic module according to the preceding claims, **characterized in that** said one or more layers (15) made of plastics are made of at least one material selected among polyvinyl chloride, polyurethane, polyacrylate, synthetic rubber or other similar and equivalent plastic materials, and are deposited with a method chosen among spreading, calendering or other similar and equivalent methods.

5. The photovoltaic module according to the preceding claims, **characterized in that** the surface (16) of said spread fabric is treated by lacquering or with acrylic resin or with a mixture of acrylic resin and fluorinated resin (PVDF- polyvinylidene fluoride), or with fluorinated resin.

6. The photovoltaic module according to the preceding claims, **characterized in that** said intermediate junction element (12) comprises a first sublayer (17), which is compatible with said lacquered surface (16), a second sublayer (18), which is compatible with said photovoltaic film (13), and a third layer (19), which is intermediate between said first sublayer (17) and said second sublayer (18) and is compatible with said first sublayer (17) and said second sublayer (18).

7. The photovoltaic module according to claim 6, **characterized in that** said first sublayer (17) is either a film of plastics based on thermoplastic polyurethane elastomers or a film made of plastics based on thermoplastic polyolefins.

8. The photovoltaic module according to claims 6 and 7, **characterized in that** said second sublayer (18) is a film made of plastics based on ethyl vinyl acetate.

9. The photovoltaic module according to the preceding claims, **characterized in that** said intermediate sublayer (19) is a film made of plastics based on polytetrafluoroethylene (PTFE) polymers or based on ethylene tetrafluoroethylene (ETFE).

10. The photovoltaic module according to the preceding claims, **characterized in that** said photovoltaic film (13) is protected on the outside by a first protective outer layer (20) made of plastics based on ethyl vinyl acetate and by a second protective outer layer (21) made of plastics based on polymers of PTFE or on polymers of ETFE.

## Amended claims

### Amended claims in accordance with Rule 137(2) EPC.

**1.** A flexible photovoltaic module (10), a base layer (11) which is mated, by interposition of an intermediate junction element (12) made of polymeric material, with a photovoltaic film (13), **characterized in that** said base layer is made of spread fabric, said spread fabric of the base layer (11) comprising a supporting fabric (14) covered with one or more layers (15) of plastics, the surface (16) of said spread fabric is treated by lacquering or with acrylic resin or with a mixture of acrylic resin and fluorinated resin (PVDF- polyvinylidene fluoride), or with fluorinated resin, said intermediate junction element (12) comprises a first sublayer (17), which is compatible with said lacquered surface (16), a second sublayer (18), which is compatible with said photovoltaic film (13), and a third layer (19), which is intermediate between said first sublayer (17) and said second sublayer (18) and is compatible with said first sublayer (17) and said second sublayer (18), said first sublayer (17) is either a film of plastics based on thermoplastic polyurethane elastomers or a film made of plastics based on thermoplastic polyolefins, said second sublayer (18) is a film made of plastics based on ethyl vinyl acetate, and said intermediate sublayer (19) is a film made of plastics based on polytetrafluoroethylene (PTFE) polymers or based on ethylene tetrafluoroethylene (ETFE).

**2.** The photovoltaic module according to claim 1, **characterized in that** said supporting fabric (14) is a high-tenacity polyester fabric or an acrylic fibre fabric or a glass fibre fabric or a mesh of metallic material or another similar and equivalent fabric.

**3.** The photovoltaic module according to the preceding claim 2, **characterized in that** said one or more layers (15) made of plastics are made of at least one material selected among polyvinyl chloride, polyurethane, polyacrylate, synthetic rubber or other similar and equivalent plastic materials, and are deposited with a method chosen among spreading, calendering or other similar and equivalent methods.

**4.** The photovoltaic module according to the preceding claims, **characterized in that** said photovoltaic film (13) is protected on the outside by a first protective outer layer (20) made of plastics based on ethyl vinyl acetate and by a second protective outer layer (21) made of plastics based on polymers of PTFE or on polymers of ETFE.
